# FASCICULE DE BREVET EUROPEEN

(11) **EP 2 491 591 B1**
(45) Date de publication et mention de la délivrance du brevet: **13.11.2013**
(21) Numéro de dépôt: 10785136.2
(22) Date de dépôt: 19.10.2010
(51) Int. Cl.: H01L 27/15, H01L 33/08, H01L 33/18, B82Y 20/00

(54) **PROCÉDÉ DE FABRICATION D'UN ÉCRAN À TRÈS HAUTE RÉSOLUTION UTILISANT UN FILM CONDUCTEUR ÉMISSIF ANISOTROPIQUE À BASE DE DIODES ÉLECTROLUMINESCENTES À NANOFILS ET ÉCRAN CORRESPONDANT**
HERSTELLUNGSVERFAHREN EINES SEHR HOCHAUFLÖSENDEN BILDSCHIRMS MIT EINER ANISOTROPISCHEN EMITTIERENDEN LEITERSCHICHT AUF BASIS VON LICHTEMITTIERENDEN DIODEN NANODRÄHTEN UND ENTSPRECHENDEM BILDSCHIRM
MANUFACTURING PROCESS OF A VERY HIGH RESOLUTION DISPLAY HAVING AN ANISOTROPIC LIGHT-EMITTING CONDUCTIVE FILM BASED ON LIGHT-EMITTING DIODE NANOWIRES AND CORRESPONDING DISPLAY

(30) Priorité: 23.10.2009 FR 0957467
(43) Date de publication de la demande: 29.08.2012
(73) Titulaire: Commissariat à l'Énergie Atomique et aux Énergies Alternatives, 75015 Paris (FR)
(72) Inventeur: TEMPLIER, François, F-38500 Voiron (FR); CLAVELIER, Laurent, F-38000 Grenoble (FR); RABAROT, Marc, F-38120 Saint-Egreve (FR)
(74) Mandataire: Colombo, Michel
(86) Numéro de dépôt international: PCT/FR2010/052218
(87) Numéro de publication internationale: WO 2011/048318

(56) Documents cités:
- EP-A1- 0 011 418
- EP-A1- 1 796 180
- WO-A1-2004/042830
- WO-A1-2007/001099
- WO-A1-2008/129859
- US-A1- 2003 168 964
- US-A1- 2005 179 052
- ZHAO JUN LIU ET AL: "GaN based active matrix light emitting diode array by flip-chip technology", 2008 ASIA OPTICAL FIBER COMMUNICATION & OPTOELECTRONIC EXPOSITION & CONFERENCE (AOE) IEEE PISCATAWAY, NJ, USA, 2008, page 3 PP., XP002585285, ISBN: 978-1-55752-863-6
- KIM H-M ET AL: "High-Brightness Light Emitting Diodes Using Dislocation-Free Indium Gallium Nitride/Gallium Nitride Multiquantum-Well Nanorod Arrays", NANO LETTERS, ACS, WASHINGTON, DC, US LNKD- DOI:10.1021/NL049615A, vol. 4, no. 6, 19 mai 2004 (2004-05-19), pages 1059-1062, XP002368212, ISSN: 1530-6984 cité dans la demande

## Description

### Domaine de l'invention

L'invention concerne la réalisation d'écrans émissifs (à pixels fixes) à très haute résolution, dont la taille de pixel est de préférence au plus égale au micron ; il peut s'agir d'écrans de petite taille (on parle parfois de « micro-écrans ») et/ou d'écrans flexibles. Ces écrans, qui peuvent être plats (même s'ils présentent une certaine courbure) sont réalisés sur des matrices actives en circuit intégré, en pratique en silicium.

### Etat de l'art et inconvénients

Il existe actuellement deux types d'écrans électro-optiques à haute résolution : les écrans à LCD (« Liquid Crystal Display ») - voir notamment le document US 6 052 162 - et les écrans à OLED (« Organic Light Emitting Diodes ») - voir notamment le document WO 2007/085554. On peut noter que, à la différence des écrans à OLED, les écrans à LCD ne sont pas des écrans émissifs).

Un problème commun à ces deux types d'écran est la difficulté de combiner des hautes résolutions (beaucoup de points images ou pixels) avec une petite taille d'écran (pour diminuer le coût). On cherche donc à réaliser des pixels de plus en plus petits ; les pixels actuels ayant une taille d'environ 5 µm, on cherche à pouvoir réaliser des pixels dont la taille est de 1 µm, voire 500 nm.

Les écrans de type LCD ou OLED sont, en général, réalisés sur une matrice active, qui est en pratique en silicium monocristallin, dans laquelle est formé un circuit intégré d'adressage à base de transistors. Il est possible également de réaliser ce circuit d'adressage à base de transistors en couches minces (TFT ou « Thin Film Transistor »). Dans ce cas, ces transistors sont réalisés dans des films de silicium amorphe ou polycristallin déposés sur un substrat de verre. Quelle que soit la technologie (LCD ou OLED), la matrice active mise en oeuvre comporte, le long de sa surface en contact avec des parties électro-optiques de l'écran, des électrodes définissant les pixels de l'écran : de manière à tirer un profit maximum de la surface de la matrice active, ces électrodes de pixel occupent la majeure partie de cette surface.

Sur cette matrice active sont rapportées des zones électro-optiques respectivement situées en regard de chaque électrode de pixel (et sous une contre électrode). Dans le cas d'un écran de type LCD, les zones électro-optiques sont constituées d'un cristal liquide dont la transparence varie en fonction de la polarisation appliquée entre les deux électrodes. Dans le cas d'un écran de type OLED, les zones électro-optiques, qui sont émissives, sont constituées d'une portion centrale d'une diode électroluminescente qui émet, ou non, un rayonnement en fonction de l'état d'excitation imposé par les transistors de la matrice active sous-jacente.

A chaque type d'écrans correspondent des types de contraintes respectives.

Dans le cas des écrans de type LCD (en pratique il s'agit plus précisément d'écrans de type LCOS réflectif (« Liquid Crystal On Silicon » réflectif sur circuit intégré) ou de type LCD transmissif sur verre (notamment commercialisé par la société Kopin) un des problèmes principaux pour les petits pixels est de contrôler l'état du cristal liquide entre des pixels adjacents. En effet, les lignes de champ créées au niveau d'un pixel peuvent influer sur les lignes de champ des pixels adjacents, en générant une perturbation au niveau de ces pixels. Cela empêche la réalisation d'écrans ayant des pixels de pas inférieur à ∼ 5 µm.

Dans le cas des écrans à OLED (tels que ceux des sociétés Emagin, MED, ou MicroOLED, notamment), les diodes OLED génèrent de la lumière blanche qui est ensuite colorée, le cas échéant, par des filtres colorés (typiquement en rouge, vert, et bleu). On a dans ce cas une matrice d'électrodes de pixel, surmontée d'un dépôt d'OLED blanc, et coopérant avec un réseau de filtres colorés qui est, soit déposé sur la matrice (cas des produits de « Emagin »), soit réalisé sur une plaque de verre et assemblé à la matrice active (cas des sociétés « MED » ou « MicroOled »).

Un premier problème se pose à propos du dépôt des couches constituant les diodes OLED sur la matrice active. En effet, les électrodes de pixel constituent en pratique des marches vis-à-vis de la surface de la matrice active ; le fait que la partie émissive soit formée de couches fait que ces marches subsistent dans cette partie émissive ; en particulier la couche conductrice formant contre électrode vis-à-vis des électrodes de pixel (il s'agit en pratique de la couche par laquelle se termine la partie émissive) comporte ainsi des marches, lesquelles constituent des risques de court-circuit (à l'emplacement des changements de niveau, les couches risquent d'être interrompues et de provoquer des contacts intempestifs). Pour réduire ce risque, il faut appliquer localement entre les pixels une résine isolante et ainsi prévoir des zones de transition, avec pour conséquence une perte d'ouverture de surface active du fait des règles de dessin (cette résine neutralise la périphérie des électrodes de pixel). Le pourcentage de surface active (parfois désigné par OAR) peut descendre à 25 % pour des pas de pixel de 5 µm. On comprend que ce problème gêne la réalisation d'écrans de type OLED à haute résolution (petit pixel) en faisant chuter le pourcentage de surface émissive.

Un second problème concerne l'utilisation de filtres colorés. En effet, que ceux-ci soient déposés directement sur la matrice active, ou assemblés à la matrice active, il y a une perte d'ouverture liée aux règles de dessin dans le premier cas, ou liée à la précision d'alignement dans le deuxième cas. Il en découle une limitation supplémentaire de l'ouverture de surface active.

Un troisième problème concerne l'extrême fragilité des couches OLEDs notamment vis-à-vis des impuretés telles que l'eau par exemple. Des encapsulations spécifiques sont mises en oeuvre, néanmoins des problèmes de vieillissement persistent avec ce type d'écran. A ces difficultés précitées s'ajoute le problème que, quelque soit la technique utilisée (LCD ou OLED), l'éventuelle présence de particules à l'interface entre la matrice active et les couches émissives génère des risques de court-circuit horizontal entre pixels adjacents (ce qui est un risque rédhibitoire qui gène considérablement la réduction des pas entre pixels et donc la résolution).

De l'état de l'art est connu de WO 2008/129859 A1 et de Zhao Jun Liu et al: "GaN based active matrix light emitting diode array by flip-chip technology", 2008, ISBN: 978-1-55752-863-6.

### Objets de l'invention.

L'invention a pour objet de pallier les inconvénients précités.

Ainsi, un objet de l'invention est un procédé selon la revendication 1 de réalisation d'un écran émissif ayant une résolution de l'ordre du micron, voire moins, de manière à permettre notamment la réalisation d'un écran de très petite taille, qui soit à la fois simple (et d'un coût acceptable à l'échelle industrielle) et fiable, sans nécessiter de complexes procédures de positionnement entre éléments à assembler.

Un autre objet de l'invention est un écran émissif selon la revendication 12 dont la résolution est de l'ordre du micron, voire moins, par exemple de l'ordre de 500 nm.

L'invention propose ainsi un procédé de réalisation d'un écran émissif à pixels, selon lequel:
* on forme une matrice active de pixels longée par une première couche formant électrode, ces pixels étant répartis selon une distribution déterminée,
* on forme un substrat formé d'un ensemble de diodes électroluminescentes constituées respectivement de nanofils parallèles, répartis dans une matrice isolante transversalement à son épaisseur avec une densité supérieure (strictement) à la densité de pixels, indépendamment de la distribution déterminée de ces pixels,
* on relie le substrat à la matrice active de pixels, d'une manière telle que seuls des sous-groupes de ces nanofils sont reliés, par une première extrémité, à des électrodes de pixel distinctes définies dans la couche formant électrode selon la distribution des pixels de la matrice active de pixels, tandis qu'au moins ces sous-groupes de nanofils sont électriquement connectés, par une autre extrémité, à une électrode commune, ces sous-groupes étant délimités au moment de cette étape de liaison en rendant émissivement inactifs les nanofils du substrat qui sont disposés entre ces sous-groupes.

Ainsi, à la différence des procédés connus, l'invention propose de constituer un ensemble de diodes électroluminescentes constituées de nanofils, indépendamment des dimensions et de la répartition des électrodes de pixel pour lesquelles on cherche à former des diodes électroluminescentes, certains au moins des nanofils ainsi formés étant ensuite émissivement inactifs, c'est à dire inutiles, soit neutralisés (c'est-à-dire qu'ils ne sont pas connectés par leurs deux extrémités à des électrodes), soit tout simplement éliminés. On comprend toutefois que le fait d'accepter de former des nanofils inutiles permet de permettre une connexion efficace entre une proportion importante de ces nanofils et les électrodes de pixel sans avoir à prévoir un positionnement précis entre le substrat et la matrice de pixels ; il en résulte une grande simplification des opérations de positionnement et de liaison entre la matrice active de pixels et le substrat comportant les nanofils.

Il en résulte en outre une simplification des opérations de formation des nanofils, puisque, compte tenu des techniques actuelles de formation des nanofils, ceux-ci peuvent aisément être, au moment de leur formation, distribués de manière homogène, c'est-à-dire de manière aléatoire sur tout le substrat sans que des précautions particulières soient prises quant à leur répartition si ce n'est que leur densité doit être sensiblement constante tout au long du substrat qui leur sert de support et supérieure à la densité des pixels. Un autre avantage est que la formation des substrats émissifs anisotropes peut être standardisée, puisqu'il n'est pas besoin de connaître les détails de l'application finale de ceux-ci, en particulier en ce qui concerne la future distribution des pixels.

En effet, les nanofils sont avantageusement distribués de manière aléatoire dans la matrice isolante avec une densité sensiblement constante.

Les techniques actuelles de formation de nanofils sont au nombre de deux :
1. La première approche consiste, à partir d'un substrat massif ou d'une couche épitaxiée, à graver des structures de nanofils, classiquement via une technique de nano-lithographie et de gravure plasma réactive (ICP (ou Inductively Coupled Plasma), RIE (ou Reactive Ion Etching), etc...). Cette approche est notamment décrite dans la référence « InGaN-GaN Nanorod Light Emitting Arrays Fabricated by Silica Nanomasks », Min-Yann Hsieh et al., IEEE journal of quantum electronics, Vol 44, pp 468-472, n° 5, May 2008. L'approche par gravure permet donc l'obtention de fils de taille nanométrique avec cependant certaines limitations qui dépendent, de la nature du matériau, des procédés de lithographie et de gravure, ... l'avantage étant que l'orientation des fils ne dépend pas a priori de l'orientation cristalline du substrat.
2. La deuxième approche consiste à faire croître des nanofils par dépôt chimique en phase vapeur par une méthode de type VLS (Vapor Liquid Solidification) qui utilise un catalyseur généralement métallique (de l'or par exemple). Les nanofils croissent souvent en relation d'épitaxie avec le substrat. De ce fait, les nanofils verticaux sont obtenus pour une orientation particulière du substrat. La position et le diamètre du catalyseur déterminent la position et le diamètre des nanofils, qui peut être inférieur à 10 nm. Cette technique présente certains avantages : facteurs de forme très importants, contrôle de dimensions des nanofils, de la composition chimique et du dopage le long des fils. Il existe également des solutions de croissance sans catalyseur utilisées pour la génération de nanofils de GaN et ZnO ou d'hétérostructures à base de ces matériaux en MOCVD (ou Metal Organic Chemical Vapor Deposition) et MBE-ou Molecular Beam Epitaxy (voir notamment « High-Brightness Light Emitting Diodes Using Dislocation-Free Indium Gallium Nitride/Gallium Nitride Multiquantum-Well Nanorod Arrays", Hwa-Mok & al, Nano Letters 2004, Vol 4, n°6, 1059-1062).

La plupart des travaux portant sur les performances de structures de LED constituées de nanofils se placent dans le cas de nanofils obtenus par croissance épitaxiale.

Dans son principe de base une LED est constituée d'une jonction P-N obtenue par dopage pendant la croissance de la zone N à la base des nanofils, ou de la couche « 2D » pour les LED « classiques », et de la zone P au sommet des nanofils ou de la couche « 2D » (cf. article ci-dessus de Min-Yann Hsieh et al.).

Il est important de noter que les actuels procédés de réalisation de LED à l'aide de films anisotropes à réseaux de nanofils mettent typiquement en oeuvre les étapes suivantes (voir les documents précités) :
- formation d'un réseau de nanofils à partir d'un substrat de croissance,
- encapsulation de ce réseau dans une matrice de verre (de type SOG (Spin On Glass) par exemple) ou de polymère (par exemple résine de lithographie)
- formation d'une électrode sur cette matrice et formation d'une électrode complémentaire sur une plage dudit substrat de croissance qui est située latéralement à l'écart du réseau de nanofils, donc à un niveau différent de celui de la première électrode.

Il est à noter que la disposition de la seconde électrode à côté des nanofils provient de la difficulté qu'il y a à intégrer, directement dans le substrat de croissance des fils, une couche conductrice ou métallique (il n'est en effet généralement pas possible de mettre en oeuvre un dopage suffisant pour permettre de constituer une telle électrode) sans nuire aux performances de croissance par épitaxie de nanofils et/ou aux performances globales du dispositif final. Il est clair que la présence de ces électrodes latérales est un obstacle à l'obtention d'écrans à haute résolution tirant profit de la quasi-totalité de leur surface.

En fait, pour surmonter cette difficulté, l'invention enseigne notamment de procéder à un transfert de la couche de nanofils noyés dans la matrice isolante sur la matrice active de pixels à partir du support ayant permis de la manipuler jusqu'au moment de l'assemblage.

L'utilisation de nanofils a aussi été proposée pour la liaison de circuits ; c'est ainsi que le document US 6 340 822 enseigne de former un ensemble de nanofils qui sont, par sous-groupes, connectés à de premiers circuits, les nanofils non utilisés étant éliminés en même temps que le support sur lequel les nanofils ont été formés (en effet, les nanofils ne sont reliés entre eux que par l'intermédiaire de ce support puisque, lorsque ces nanofils sont noyés dans une couche, celle-ci est une couche sacrificielle (par exemple métallique) qui ne sert que pour l'égalisation des longueurs des divers nanofils) ; en variante, les nanofils sont formés en groupes selon la géométrie des circuits auxquels ils sont destinés à être fixés. Les extrémités libres des nanofils ainsi fixés aux premiers circuits peuvent ensuite être fixées à de seconds circuits amenés précisément en regard des premiers circuits (des entretoises peuvent être prévues pour éviter le flambage des nanofils et maintenir l'écartement entre les circuits). On comprend que les ensembles de nanofils sont une source de fragilité, au cours de leur fabrication ainsi qu'au sein des assemblages auxquels ils participent, puisqu'ils ne sont reliés les uns aux autres que par l'intermédiaire des circuits auxquels ils sont fixés par leurs extrémités ; en outre, leur fixation aux seconds circuits nécessite un positionnement précis de ceux-ci par rapport aux premiers circuits. L'enseignement de ce document implique donc des procédures complexes et coûteuses. Il est à noter que ce document ne se préoccupe pas de former un réseau de pixels.

Selon des caractéristiques avantageuses de la présente invention, éventuellement combinées :
- au cours de l'étape de formation du substrat anisotrope, on dépose sur la matrice isolante une couche de matériau électriquement conducteur qui est en contact électrique avec de premières extrémités de ces nanofils qui sont opposées à de secondes extrémités reliées à un support de cette matrice, l'étape de liaison comportant la mise en contact intime de cette couche de matériau électriquement conducteur avec la couche formant électrode; la couche de matériau électriquement conducteur et la couche formant électrode comportent avantageusement un même matériau,
- lors de l'étape de formation de la matrice active de pixels, on délimite les électrodes de pixel tandis que, au cours de l'étape de formation du substrat, on délimite dans la couche de matériau électriquement conducteur un réseau de plots électriquement conducteurs disjoints tels que chacun soit connecté à au moins la première extrémité d'un nanofil, l'écartement entre des plots adjacents étant supérieur à la largeur de ces premières extrémités et l'écartement entre les électrodes de pixel étant supérieur à la taille des plots, en conséquence de quoi, lors de l'étape de liaison, certains des plots sont connectés à l'une des électrodes de pixel tandis que d'autres plots sont à distance des électrodes de pixel les plus proches en leur étant électriquement isolés, les nanofils reliés à ces plots isolés étant émissivement inactifs ; de préférence, les plots ont des dimensions telles que chaque plot est connecté à au moins une dizaine de nanofils tandis que chaque électrode de pixel est connectée à au moins une dizaine de plots ; de manière également préférée, le réseau des électrodes de pixel et le réseau des plots métalliques sont des réseaux 2D à mailles carrées ; de manière avantageuse, les plots ont des dimensions inférieures à 200 nm tandis que les pixels ont des dimensions inférieures à 1 micron,
- au cours de l'étape de formation de la matrice active de pixels, on forme la couche formant électrode sous la forme d'une couche électriquement conductrice continue et, au cours de l'étape de formation du substrat anisotrope, on forme la couche en matériau électriquement conducteur sous la forme d'une couche conductrice continue et, au cours de l'étape de liaison, on délimite dans l'ensemble de nanofils du substrat un réseau de sous-groupes de nanofils séparés par des cloisons en matière isolante tout en délimitant dans la couche continue lesdites électrodes de pixel en regard de ces sous-groupes, les nanofils situés entre ces sous-groupes étant éliminés ; de manière avantageuse, l'on délimite les sous-groupes de nanofils et les électrodes de pixel par gravure au travers du substrat, au travers de la couche conductrice continue et jusqu'au travers de la couche continue formant électrode puis l'on procède au remplissage des zones gravées avec de la matière isolante ; de manière plus particulièrement préférée, le matériau isolant de remplissage est le même que le matériau de la matrice isolante,
- au cours de l'étape de formation du substrat anisotrope, on provoque la formation dudit ensemble de nanofils à partir d'un substrat de croissance, et on encapsule cet ensemble de nanofils dans la matrice isolante sur une épaisseur constante en sorte de laisser à nu de premières extrémités des nanofils (à titre d'exemple, on dépose un oxyde qui englobe et recouvre les nanofils puis on planarise la surface, par CMP par exemple (c'est-à-dire un polissage mécano-chimique) jusqu'à mettre à nu les premières extrémités des nanofils),
- l'on forme l'électrode commune après mise en contact de la matrice active de pixels avec ce substrat anisotrope, les électrodes de pixel étant délimitées (soit parce que cette délimitation a eu lieu au moment de la formation de la matrice active, soit parce que ces électrodes ont été délimitées après assemblage).

Selon d'autres caractéristiques avantageuses :
- l'étape d'encapsulation comporte une sous-étape de creusement propre à libérer (dénuder) une portion de la surface latérale des nanofils en plus de leurs premières extrémités (de leurs tranches), de sorte que le matériau électriquement conducteur déposé sur le matériau électriquement isolant enrobe les nanofils sur une portion de leur longueur,
- les nanofils sont formés en sorte d'être dopés d'un premier type, soit n, soit p, sur une fraction donnée de leur longueur à partir desdites extrémités, et le creusement est réalisé sur une profondeur au plus égale à la longueur de cette zone dopée desdits nanofils,
- les nanofils forment des multi puits quantiques réalisés par épitaxie et dopage adapté pendant l'épitaxie afin d'améliorer l'émission de lumière,
- on élimine le support du substrat anisotrope émissif par rodage et abrasion jusqu'à consommation de ce substrat de croissance,
- après l'élimination de ce support, on creuse la couche de matériau électriquement isolant en sorte de libérer (dénuder) une portion de la surface latérale des nanofils (en plus de leurs autres extrémités) sur une partie de leur longueur ; cela permet de les doper et/ou de les enrober dans une couche conductrice assurant ainsi une très bonne conduction électrique entre ces extrémités et la couche conductrice à laquelle ces extrémités sont reliées,
- les nanofils sont formés en sorte d'être dopés (du type opposé au premier type, si les premières extrémités sont dopées) sur une fraction donnée de leur longueur à partir desdites autres extrémités, et le creusement est réalisé sur une profondeur au plus égale à la longueur de cette zone dopée desdits nanofils,
- les nanofils ont un rapport de l'ordre de 10 entre leur hauteur et leur diamètre, voire supérieur à 10,
- la densité des nanofils est au moins égale à 10⁷ /cm², de préférence au moins égale à 10⁹ /cm²; cette densité est de préférence au moins 5 fois (voire 10 fois) supérieure à celle des pixels,
- les nanofils sont en GaN, ZnO, InGaN, ...

L'invention propose en outre un écran adapté à être obtenu par le procédé précité.

L'invention propose ainsi un écran émissif à pixels conformément à la revendication 12.

Selon un mode avantageux de réalisation conformément à la présente invention, à chaque électrode de pixel sont connectés plusieurs plots, l'écartement entre ces plots étant supérieur à la largeur des nanofils, et les dimensions de chaque plot étant inférieures à l'écartement existant entre des électrodes de pixel adjacentes.

Selon un autre mode avantageux de réalisation conformément à la présente invention, à chaque électrode de pixel correspond un seul plot de mêmes dimensions, tous les nanofils étant répartis entre lesdits sous-groupes.

Les électrodes de pixel ont avantageusement une dimension au plus égale à 1 micron environ, avec des espacements d'au plus 200 nm.

De manière préférée, les nanofils du substrat émissif anisotrope sont répartis dans la matrice isolante indépendamment de la distribution des pixels, des nanofils situés entre les sous-groupes connectés aux électrodes de pixel au travers desdits plots étant émissivement inactifs.

### Description de l'invention

Des objets, caractéristiques et avantages de l'invention ressortent de la description qui suit, donnée à titre d'exemple illustratif non limitatif, en regard des dessins annexés sur lesquels :
- la figure 1 est une vue schématique d'un substrat anisotrope émissif sur le point d'être assemblé avec une matrice active de pixels,
- la figure 2 est une vue schématique de l'assemblage ainsi obtenu,
- la figure 3 est une vue schématique d'une première étape de formation du substrat de la figure 1, mettant en oeuvre la formation d'un ensemble homogène de nanofils,
- la figure 4 en est une autre vue schématique après encapsulation des nanofils et planarisation, typiquement par CMP, pour faire affleurer les tranches des fils,
- la figure 5 en est une autre vue schématique après dénudage des extrémités des nanofils,
- la figure 6 en est une autre vue schématique après dépôt d'une couche conductrice connectée aux dites extrémités,
- la figure 7 est un schéma d'un substrat anisotrope émissif à base de nanofils, après formation d'un ensemble de plots regroupant chacun plusieurs nanofils, selon une variante de réalisation de réalisation,
- la figure 8 est une vue schématique de dessus de la matrice active de pixels,
- la figure 9 est une vue schématique du substrat de la figure 6, après la formation d'un ensemble de plots, conformément au schéma de la figure 7,
- la figure 10 est une vue schématique de la matrice active de pixels à laquelle le substrat de la figure 9 est sur le point d'être assemblé,
- la figure 11 est une vue schématique de l'assemblage du substrat de la figure 7 avec la matrice active de la figure 10,
- la figure 12 en est une vue schématique après élimination du support du substrat de la figure 7,
- la figure 13 en est une vue schématique après dénudage des extrémités des nanofils,
- la figure 14 en est une vue schématique après dépôt d'une couche conductrice connectée avec lesdites extrémités dénudées,
- la figure 15 est une autre vue schématique d'un substrat tel que celui de la figure 6 sur le point d'être assemblé, selon un autre exemple de réalisation, avec une matrice active de pixels recouverte d'une couche conductrice continue, dans laquelle des électrodes de pixel n'ont pas encore été délimitées,
- la figure 16 en est une vue schématique après élimination du support des nanofils et dépôt d'une couche continue,
- la figure 17 en est une autre vue schématique après formation d'un masque sur la couche continue,
- la figure 18 en est une autre vue schématique après gravure de la couche continue au travers du masque,
- la figure 19 en est une autre vue schématique après gravure du substrat anisotrope émissif au travers dudit masque,
- la figure 20 en est une autre vue schématique après gravure de la couche continue de la matrice active de pixels au travers dudit masque, et
- la figure 21 en est une autre vue schématique après remplissage des tranchées résultant des opérations de gravure et formation d'une électrode continue sur les portions du substrat.

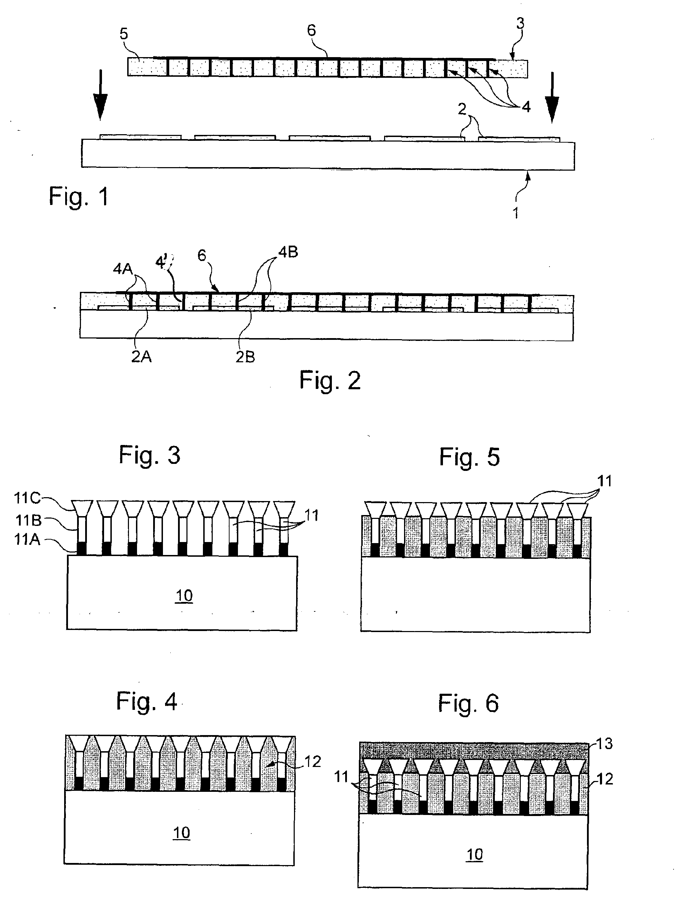

Les figures 1 et 2 représentent de manière schématique la formation d'un écran émissif à pixels, pouvant être à très haute résolution malgré une petite taille (donc à très faible pas), selon un exemple de mise en oeuvre de l'invention.

On forme d'une part une matrice active de pixels 1, longée par une première couche électriquement conductrice formant électrode, ces pixels étant répartis selon une distribution déterminée (typiquement selon un réseau 2D à maille rectangulaire, voire carrée). Dans l'exemple représenté, des électrodes de pixel 2 distinctes ont déjà été formées dans cette couche formant électrode.

Par ailleurs, on forme un substrat anisotrope émissif 3 formé d'un ensemble de diodes électroluminescentes constituées chacune de nanofils 4 parallèles et répartis dans une matrice isolante 5 transversalement à l'épaisseur de ce substrat. Dans l'exemple représenté, ces nanofils 4 sont déjà connectés, par leurs extrémités situées à l'opposé de la matrice active de pixels, à une électrode commune 6. La répartition des nanofils dans le substrat est homogène (quoiqu'aléatoire) en ce sens que leur densité est sensiblement constante, sans que l'on puisse identifier des groupes séparés par des cloisons isolantes. Ainsi que cela ressort ci-dessous, la formation de ces nanofils n'a en effet pas besoin de tenir compte de la géométrie ou de la répartition des électrodes de pixels de la matrice active 1.

On relie le substrat à la matrice active de pixels, d'une manière telle (voir la figure 2) que seuls des sous-groupes, non identifiés au sein du substrat avant l'opération de liaison, sont connectés, par une première extrémité (extrémité basse) aux électrodes de pixels 2 ; on comprend que la distribution des sous-groupes est déterminée par la distribution des électrodes de pixel.

Par contre, des nanofils ne faisant pas partie de ces sous-groupes ont leurs extrémités basses qui sont à l'écart des électrodes de pixels ; ils sont donc émissivement inactifs.

On observe ainsi que les nanofils repérés 4A sont connectés à une première électrode 2A tandis que les nanofils repérés 4B sont connectés à une seconde électrode 2B, alors que des nanofils 4' sont neutralisés, n'étant connectés à aucune électrode. Il importe peu que le nombre de nanofils soit identique ou non au sein des sous-groupes.

De par leur forme (ils sont séparées par de l'isolant), il n'y a pas de conduction horizontale, du point de vue électrique, entre les nanofils ; c'est une structure de type 'film conducteur anisotropique'.

Ainsi, il n'y a pas possibilité de court circuit entre deux pixels voisins par le biais de la couche émissive.

Il va de soi (voir ci-dessous) que les figures 1 et 2 ne sont pas à une échelle réelle, les dimensions des nanofils étant en pratique très inférieures à celles des électrodes de pixel.

On comprend que le seul fait que le substrat soit mis en regard de la matrice active de pixels suffit à déterminer, au sein de l'ensemble de nanofils, ceux qui contribuent à l'effet de diode électroluminescente (c'est-à-dire qu'ils sont émissifs), tandis que d'autres, qui ne sont connectées qu'à l'électrode commune 6, peuvent subsister dans le substrat (sans être émissifs) sans nuire aux performances de l'écran ainsi formé.

Il en découle que le positionnement relatif entre la matrice active de pixels 1 et le substrat anisotrope émissif 3 est défini avec une précision qui n'a pas besoin d'être à l'échelle des électrodes de pixels.

A titre d'exemple, les émetteurs 4 sont des diodes électroluminescentes en GaN, faites en nanofils, avec des dimensions qui sont typiquement les suivantes (« ∼ » signifiant que la valeur qui suit est approximative) : largeur : ∼20 nm ; hauteur ∼400 nm ; densité linéaire : 10 à 50 µm⁻¹, ce qui correspond à des espacements de l'ordre de quelques nanomètres ou de quelques dizaines de nanomètres, ce qui est très inférieur aux dimensions des électrodes de pixel qui sont de quelques microns ou quelques centaines de nanomètres). Ils émettent une longueur d'onde qui peut être fixe ou distribuée, en fonction des dimensions, notamment latérales. Les émetteurs 4 sont séparés par un isolant 5 qui peut être un polymère ayant des propriétés de souplesse (limite de rupture à l'élongation grande) ou une couche inorganique type SOG (« Spin On Glass » en anglais).

La couche conductrice 6 formant une électrode commune, reliant toutes les parties supérieures des diodes, peut être une couche de métal très mince pour rester transparente (ex : Ag 20 nm), ou une couche d'un matériau transparent conducteur comme de type ITO (à savoir un oxyde d'indium dopé à l'étain, ou « Indium Tin Oxide »).

La matrice active de pixels est typiquement réalisée dans une matrice de silicium monocristallin, mais en variante il peut s'agir de transistors TFT réalisés en silicium amorphe ou polycristallin déposé sur un substrat de verre. Il est à la portée de l'homme de métier de réaliser une telle matrice de pixels avec un pas de l'ordre d'un micron, voire de l'ordre de quelques centaines de nanomètres.

La couche émissive ainsi obtenue est souple, laminable sur un support qui peut être une matrice active (un tel laminage est en effet une forme possible pour réaliser l'assemblage de la couche émissive 3 avec la matrice active de pixels 1).

Les figures 3 à 6 représentent des étapes de formation d'un substrat formé de nanofils adaptés à former des diodes électroluminescentes (à hétérojonction), dont deux exemples d'utilisation sont ensuite décrits (ce substrat n'est pas encore un substrat anisotrope émissif au sens des figures 1 et 2).

La figure 3 représente une configuration de départ, avec un substrat de départ 10 (aussi appelé ici substrat de croissance) sur lequel a été formé, de toute manière connue appropriée, un réseau de nanofils 11 semiconducteurs (par croissance ou par gravure, notamment), de manière homogène, c'est-à-dire sans chercher à réaliser un quelconque réseau présentant des zones denses et des zones sensiblement dépourvues de nanofils.

A titre d'exemple, le substrat de croissance est formé de silicium d'orientation <111> et les nanofils sont en GaN, avec une partie basse 11A qui est dopée « n », ici par du silicium (provenant du substrat 10), une partie médiane 11B qui peut comporter une partie non dopée intrinsèque comportant éventuellement une zone de multi-puits quantiques (MQW - « Multiple Quantum Wells »), et une partie supérieure 11C qui est dopée « p », ici par du magnésium ; l'ensemble forme une structure appelée « P-I-N ».

La figure 4 représente la configuration obtenue après une étape d'encapsulation des nanofils et de planarisation réalisée en sorte de remettre à nu les extrémités des nanofils à connecter électriquement.

L'encapsulation des nanofils est avantageusement réalisée par dépôt d'un matériau électriquement isolant 12, par exemple une couche de silice (SiO₂) ou une couche de polymère (typiquement une résine classique de lithographie), ou une couche de matériau type sol-gel. Ce dépôt englobe et recouvre les nanofils. Il est suivi d'une étape de planarisation de la surface. Cette planarisation est par exemple réalisée au moyen d'une étape de polissage mécano-chimique (CMP - « Chemical Mechanical Polishing »), ou d'une gravure ionique réactive (RIE - « Reactive Ion Etching »).

La planarisation de la couche d'encapsulation se traduit par le fait que les premières extrémités supérieures (plus particulièrement leurs tranches) des nanofils sont libres, au même niveau que la surface libre du matériau d'encapsulation.

De manière avantageuse (voir la figure 5), on creuse la couche d'encapsulation en sorte de dégager le sommet des nanostructures et ainsi d'augmenter la surface disponible pour un contact électrique (celle-ci comprend en effet non seulement les premières extrémités (les tranches) de ces nanostructures mais aussi une partie de leurs surfaces latérales). Dans l'exemple représenté, la hauteur de la portion des nanofils qui est ainsi libérée est celle qui correspond à la zone de dopage « p » des nanofils de GaN ; cette hauteur pourrait en variante être inférieure à la hauteur de la zone dopée « p ».

L'étape suivante (voir la figure 6) est une étape de dépôt et de planarisation d'une couche métallique 13 (ou d'un ensemble de couches) permettant d'assurer la continuité du contact électrique (contact ohmique) avec chacun des nanofils émergeant de la couche d'encapsulation 12.

Grâce à sa très bonne planéité, la surface de la couche de nanofils ainsi réalisée (11+12+13) est adaptée à être reliée avec une grande tenue mécanique à la matrice active de pixels (comme indiqué ci-dessus il peut s'agir d'un assemblage par laminage, ce qui peut se traduire par un collage moléculaire, permettant une bonne continuité de conduction électrique).

On comprend que les nanofils 11 correspondent aux nanofils 4 des figures 1 et 2, tandis que le matériau isolant 12 correspond à la matrice 5 de ces figures.

Il est à noter que le substrat de la figure 6 constitue un produit intermédiaire qui peut être obtenu d'une manière quelconque, pouvant être différente de celle décrite aux figures 3 à 6.

Dans l'exemple schématique de réalisation des figures 1 et 2, le substrat formé de nanofils encapsulés est collé sur la matrice active de pixels sans mettre en oeuvre les étapes optionnelles des figures 5 et 6.

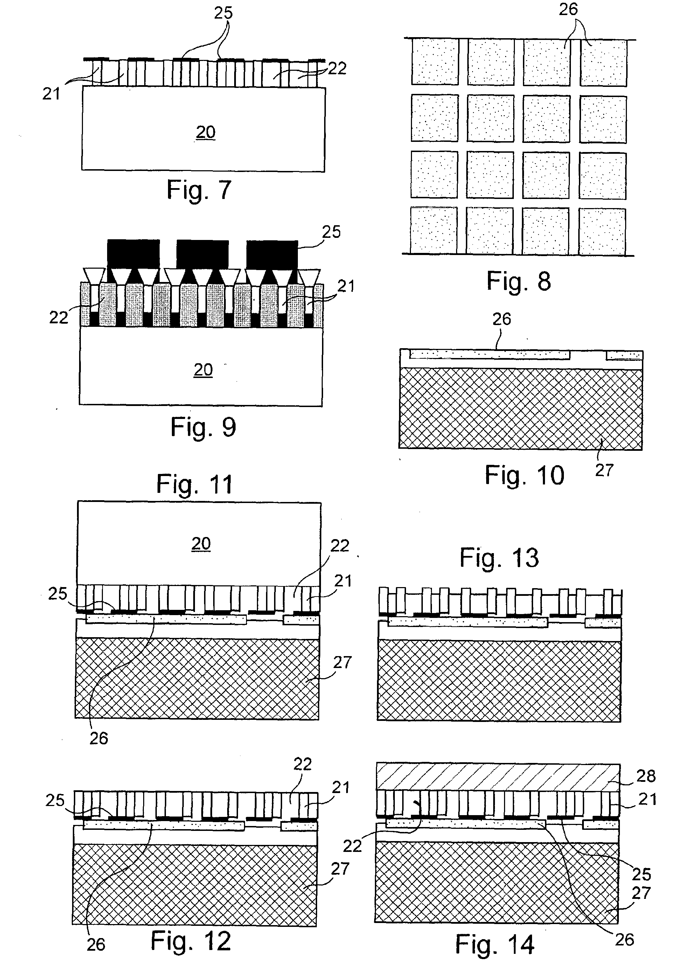

Les figures 7 à 14 représentent schématiquement une variante de ce premier exemple de réalisation d'un écran à haute résolution conforme à l'invention à partir du produit de la figure 6, qui a l'avantage par rapport aux figures 1 et 2 d'assurer une bonne protection des extrémités des nanofils lors de leur fixation à la matrice active de pixels. Le principe de cette variante est schématisé aux figures 7 et 8 tandis que sa réalisation est représentée plus en détail aux figures 9 et 10, d'une part et aux figures 11 à 14 d'autre part.

Les éléments de ces figures qui sont similaires à ceux des figures 3 à 6 sont désignés par des signes de référence qui se déduisent de ceux de ces figures 3 à 6 par addition du nombre 10.

Ainsi que cela ressort de la figure 7, au lieu d'avoir des extrémités « libres » (opposées au support 20) toutes indépendantes les unes des autres, les nanofils 21 de la figure 7 sont connectés par lesdites extrémités libres à des plots (ou îlots) conducteurs 25 répartis selon une distribution avantageusement régulière, selon un réseau à deux dimensions, ici à pas constant.

L'intérêt premier de ces plots est de regrouper par paquets les nanofils (ou nanotubes) qui sont alors électriquement connectés au niveau de l'une de leur extrémité et de faciliter l'assemblage avec la matrice active entre ces plots et les électrodes disposées sur la matrice active.

Un autre intérêt de prévoir de tels plots est de permettre d'avoir, sur la surface destinée à être reliée à la matrice active de pixels, des zones conductrices 25 qui sont réparties de manière plus régulière que les nanofils eux-mêmes. En effet (voir ci-dessus), lors de la fabrication de l'ensemble des nanofils, ceux-ci présentent en pratique une distribution qui présentent des variations géométriques (il n'y a pas nécessairement d'alignements parallèlement au support, leurs sections (approximativement rondes de sorte qu'on peut les caractériser par un diamètre) peuvent présenter des variations de plusieurs nanomètres tandis que leurs espacements peuvent présenter des fluctuations pouvant être de l'ordre de plusieurs dizaines de nanomètres). La présence des plots permet de former des sous-groupes de nanofils plus régulièrement répartis, et la taille des plots est avantageusement suffisamment grande par rapport aux sections des nanofils pour que, statistiquement, malgré les fluctuations géométriques à l'échelle du nanomètre, il y ait un nombre sensiblement constant de nanofils connectés à chacun des plots.

C'est par l'intermédiaire de ces plots 25 que le substrat est ensuite relié et connecté à la matrice de pixels dont on voit à la figure 8 que les électrodes de pixel 26 sont réparties selon la distribution souhaitée pour l'écran à réaliser, en pratique un réseau à deux dimensions, de préférence selon deux directions perpendiculaires ; ces électrodes sont typiquement rectangulaires, par exemple carrées (comme indiqué sur cette figure 8) auquel cas les pas entre plots selon les deux directions du réseau peuvent être identiques.

Ces plots ont des formes et des tailles telles que, suivant chaque direction transversale aux nanofils, l'écartement entre des plots adjacents est sensiblement supérieur à la section maximale d'un nanofil (typiquement d'au moins 25%), et telles que, également suivant chaque direction transversale parallèle à la couche formant électrode, l'écartement entre des électrodes de pixel adjacentes soit supérieure à la dimension maximale des plots (typiquement d'au moins 25%).

On comprend que, pour des raisons de lisibilité, le réseau d'électrodes de pixels de la figure 8 est représenté avec une taille trop faible pour respecter ces règles.

En théorie, la distance minimale entre deux pixels sans risque de court circuit est la largeur d'une diode, soit 20 nm environ. En réalité, la distance minimale entre pixels est fixée par la technologie microélectronique pour réaliser les électrodes de pixel, qui est actuellement de l'ordre de 0.1 à 0.5 µm. La taille minimale de pixel est aussi fixée par la technologie microélectronique de réalisation des parties actives associées à chaque pixel, ce qui permet a priori de réaliser des pixels aussi petits que 1 µm de côté (voire 500 nm), soit une densité de l'ordre de 1000 pixels par mm soit 25400 pixels par pouce, et donc un écran à très forte résolution pour une dimension réduite (exemple : résolution HDTV (« High Definition TV ») obtenue sur une puce de 2 x 3 mm).

A titre d'exemple, les nanofils ont un diamètre de 20 nm environ avec un espace pouvant varier de 5 à 80 nm (soit un pas variant de 25 à 100 nm).

A titre d'exemple également, la matrice active de pixels est réalisée sur silicium, en technologie microélectronique. Les électrodes de pixel sont des pavés conducteurs typiquement en cuivre, avec une taille de 1 à 5 µm de coté (voire moins), espacés par exemple de 100 nm ; ils peuvent être délimités par damascène ou gravure sèche.

L'invention permet d'avoir ainsi 100 % de la surface d'électrode émissive (au taux de remplissage surfacique de diodes près), et un pourcentage émissif global très élevé même pour de très petits pixels car l'espace entre pixels est très réduit (exemple : pixels de 1 µm de côté, espacés de 0.1 µm d'écart, ce qui donne une ouverture émissive d'environ 80 %).

Ainsi que cela est représenté à la figure 9, les plots 25 sont formés dans la couche métallique conductrice 13, et les électrodes de pixel de la figure 10 sont bien plus grandes (pour respecter un peu mieux la proportion avec les plots qu'à la figure 8, un seul pixel entier 26 y est représenté). La partie microélectronique servant à la commande des pixels au sein de la matrice active de pixels est désignée sous la référence 27 (les parties associées à chaque pixel n'y sont pas différentiées).

On comprend que la liaison avec la matrice active de pixels est particulièrement efficace lorsque celle-ci comporte en surface une couche dans un matériau identique (ou de composition voisine) à celle de la couche 13 ; il y a donc un intérêt à choisir pour la couche 13, et donc les plots 25, un même matériau conducteur que pour la couche formant électrode.

Une manière d'obtenir les plots 25 est de procéder par lithographie et gravure du métal. Comme indiqué ci-dessus :
- la taille de ces plots est liée aux dimensions et espacements des nanofils, aux performances des techniques lithographiques, et à l'espacement entre pixels,
- le principe est que ces plots sont petits devant la taille des pixels, et légèrement plus petits que les espaces entre pixels.

Il est important de noter qu'ainsi, on peut assembler le film anisotrope et la matrice active sans avoir à assurer un alignement précis (les directions du réseau des plots peuvent ainsi être inclinées par rapport à celles des directions du réseau des électrodes de pixel).

L'assemblage du substrat de la figure 7 avec la matrice active de la figure 10 est représenté plus en détail aux figures 11 à 14.

A la figure 11, le substrat est mis en contact intime avec la matrice, par l'intermédiaire des plots et des électrodes de pixel (il se produit un collage moléculaire), sans précaution particulière quant à la mise en regard entre plots et électrodes puisque les plots sont plus petits que les espaces entre électrodes (il n'y a donc pas de risque de court-circuit entre électrodes adjacentes par un plot ; il est rappelé en outre que, puisque le substrat est anisotrope, il n'y a pas de risque de court-circuit entre plots adjacents). Il n'y a donc pas de précaution à prendre pour assurer un quelconque alignement entre les nanofils et les électrodes de pixel : le procédé est un procédé auto-aligné.

On peut alors (voir la figure 12) procéder, de toute manière appropriée, au démontage du substrat 20 vis-à-vis de la couche constituée par les nanofils encapsulés dans leur matrice isolante. Ce démontage peut être obtenu notamment par attaque chimique humide ou sèche, ou par érosion.

De manière préférée, on procède ensuite (voir la figure 13) à une attaque de la matière isolante 22, sur une faible partie de son épaisseur pour dénuder les extrémités supérieures des nanofils (situées à l'opposé de celles connectées à la matrice active de pixels). Un éventuel traitement de planarisation peut être appliqué (les tranches supérieures des nanofils sont ainsi mises à nu).

On dépose ensuite (voir la figure 14) une couche conductrice 28 connectée aux extrémités supérieures de tous les nanofils (y compris ceux qui sont connectés à des plots non connectés à une électrode de pixel). Cette couche formant électrode commune pour tous les nanofils a avantageusement une épaisseur suffisamment fine pour être transparente (compte tenu du matériau choisi). On comprend que la connexion entre les nanofils et cette électrode est améliorée lorsque, ainsi que cela est représenté à la figure 13, ces extrémités ont été dénudées sur une fraction de leur hauteur. Grâce à cette électrode commune et aux électrodes de pixel, les nanofils peuvent alors devenir émissifs, en fonction de ce que détermine la portion de la matrice active qui correspond à chacune des électrodes de pixel.

Le produit ainsi obtenu est un écran émissif à pixels ayant une très forte résolution :

Le pas de pixel est très faible, étant de l'ordre de 1 micron, voire seulement de l'ordre de 0.5 µm (dans les solutions connues, la limite inférieure de taille de pixel pour produire de manière fiable, à l'échelle industrielle, des micro-écrans à haute densité de pixel est en pratique de l'ordre de 5 µm).

L'écart entre pixels peut n'être que de 0.1 µm, voire moins (alors que dans l'état de la technique cet écart est au moins de 0.2 µm).

En ce qui concerne le pourcentage de surface émissive de l'écran obtenu :
- il est de l'ordre de 96% si les électrodes ont un pas de 5 µm et un écart de 0.1 µm (ce taux n'est que de l'ordre de 60% dans l'état de la technique),
- il est de l'ordre de 81% si les électrodes ont un pas de 1 µm et un écart de 0.1 µm (alors que ces dimensions n'existent pas dans l'état de la technique).

Il est à noter que la délimitation des sous-groupes de nanofils connectés respectivement aux électrodes de pixel, parmi la pluralité de nanofils répartis dans la matrice indépendamment de la distribution des électrodes de pixel (de préférence de manière aléatoire avec une densité sensiblement constante), a lieu au moment de la mise en contact du substrat avec la matrice, au travers des plots et des électrodes de pixel (voir la figure 11) ; de même la sélection, au sein des nanofils du substrat, de ceux qui sont finalement émissivement inactifs résulte de cette même étape de mise en contact, sans qu'il y ait eu à prévoir de précaution particulière d'alignement.

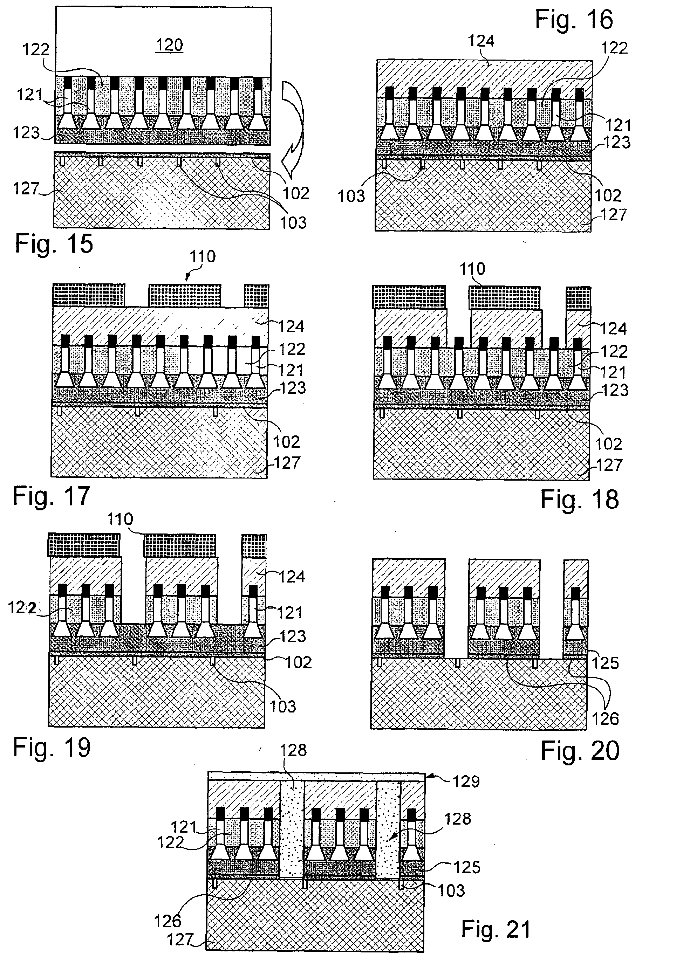

Une variante du procédé de réalisation est schématisée sur les figures 15 à 21. Sur ces figures, les éléments similaires à ceux des figures 7 à 14 sont désignés par des chiffres de référence qui se déduisent de ceux de ces figures précédentes par addition du nombre 100.

Les principales différences entre cette variante et le procédé des figures 7 à 14 concernent le fait que les nanofils inutiles sont supprimés et par le fait que la délimitation des électrodes de pixel a lieu après assemblage de la couche de nanofils encapsulés avec la matrice active de pixels (simultanément à la détermination de plots qui sont en exacte correspondance avec ces électrodes de pixel (il n'est plus nécessaire de prévoir que les plots sont plus petits que l'écart entre électrodes)).

En d'autres termes, selon cette variante du procédé de l'invention, on commence par assembler un film émissif anisotropique (encore sur son support de fabrication) et une matrice active, puis on définit les pixels par gravure de ce film.

Ainsi que cela ressort de la figure 15, on commence par assembler (comme à la figure 11) un substrat identique à celui de la figure 6 sur une matrice active de pixels incomplète par rapport à celle de la figure 10, en ce sens qu'on forme une couche conductrice continue 102 dans laquelle des électrodes de pixel n'ont pas encore été délimitées ; toutefois, comme dans la matrice active de pixels des figures 1 ou 10, il y a des connexions entre cette couche d'électrode 102 et les portions de commande individuelle de pixels, en pratique constituées par des transistors de commande de pixel (repérées sur la figure 15 sous la référence 103 alors qu'elles ne sont pas représentées à la figure 1 ou à la figure 10).

Comme précédemment, cette matrice active de pixels est réalisée sur silicium, en technologie microélectronique.

Cet assemblage est de très bonne qualité, notamment du point de vue conductivité électrique puisqu'il est réalisé le long de deux couches électriquement conductrices (métalliques), à savoir la couche d'électrode 102 et la couche conductrice 123 connectées aux extrémités des nanofils situées à l'opposé du support 120 de ces nanofils. Comme précédemment, ces couches conductrices métalliques sont avantageusement réalisées en des matériaux identiques ou ayant des compositions voisines.

Cet assemblage ne nécessite par de précautions particulières quant au positionnement relatif entre la couche de nanofils encapsulés et la matrice active de pixels incomplète.

Après assemblage, on démonte le support 120 vis-à-vis des nanofils 121 encapsulés dans la matrice isolante 122 (comme à la figure 12). De manière avantageuse, on grave en outre la matrice isolante de manière à dénuder les extrémités supérieures des nanofils sur une partie de leur hauteur (comme à la figure 13), puis on dépose une couche conductrice 124 encapsulant ces extrémités (comme à la figure 14 - voir la figure 16). Cette couche conductrice peut être formée de la même manière que la couche 28 de la figure 14, par exemple par dépôt ITO.

C'est ensuite que l'on délimite à la fois des lots de nanofils au sein de l'ensemble de la couche de la figure 6 et que l'on délimite les électrodes de pixel, par gravure de motifs (« patterning » en anglais) ; ces motifs sont en pratique des rectangles, ou des carrés, de côté avantageusement choisi inférieur à 5 microns, de l'ordre d'un micron voire moins (par exemple de l'ordre de 500 nm), avec un espacement très inférieure à ce côté, typiquement de quelques centaines de nanomètres, par exemple de 200 nm.

Pour ce faire, on commence par déposer un masque de résine 110 correspondant aux motifs à réaliser (voir la figure 17).

Puis on procède à la gravure, par exemple par plasma, de la couche conductrice 124 (voir la figure 18).

Puis on procède à la gravure, par tout moyen approprié, des nanofils et de la matière isolante située sous les zones gravées de la couche 124 (on poursuit le creusement au travers du masque 110 - voir la figure 19).

On procède enfin à la gravure des couches conductrices 123 et 102, par tout moyen approprié, puis à l'élimination du masque de résine (voir la figure 20) ; on forme ainsi des plots 125 connectés à des groupes de nanofils, ainsi que des électrodes de pixel 126 qui sont très exactement en regard.

On comprend que le masque de résine doit être positionné vis-à-vis de la matrice active de pixels de manière à ce que chacun des motifs soit en regard d'une des connexions 103. Il est toutefois à noter que la précision d'un tel positionnement est simplement de l'ordre du pixel.

Il est à noter en effet que la délimitation des sous-groupes de nanofils connectés respectivement aux électrodes de pixel, parmi la pluralité de nanofils initialement répartis dans la matrice indépendamment de la distribution des électrodes de pixel (de préférence de manière aléatoire avec une densité sensiblement constante), a lieu, au sein de l'étape de liaison, au moment du dépôt du masque de gravure (voir la figure 17) ; de même la sélection, au sein des nanofils du substrat, de ceux qui sont finalement émissivement inactifs (c'est-à-dire ici éliminés) résulte de même de ce masque de gravure, sans qu'il y ait eu à prévoir de précaution particulière d'alignement entre les sous-groupes et les électrodes de pixel (puisqu'un même masque sert à délimiter les sous-groupes et les électrodes de pixel).

On remplit alors les tranchées formées par gravure avec une matière isolante 128 (par exemple par un matériau identique ou similaire à celui de la matrice 122 encapsulant les nanofils).

Pour assurer une connexion entre les diverses portions de la couche 124, on dépose enfin une couche conductrice 129, avantageusement avec le même matériau que cette couche 124 et par le même procédé (ITO dans l'exemple considéré).

En fait, ce procédé permet une moins bonne précision que celui des figures 7 à 14 en raison du fait que l'on doit aligner le masque de gravure au niveau du pixel et ensuite graver successivement plusieurs couches. C'est pourquoi, selon ce procédé, la taille minimale de pixel semble devoir être plutôt de l'ordre de 1 à 2 µm (au lieu de 0.5 à 1 µm dans le procédé précédemment décrit), avec un espacement minimum de l'ordre de ∼200 nm (alors que le procédé précédent permet de descendre à au moins 100 nm).

Cependant, comme avec le procédé précédent, ce procédé des figures 15 à 21 apporte un gain notoire par rapport à l'état de l'art, notamment du fait que les nanofils sont autoalignés par rapport aux électrodes de pixel et sont anisotropes (il n'y a donc pas de risque de courts-circuits transversaux entre pixels, sans avoir à réduire l'ouverture émissive).

Il est à noter qu'on peut réaliser des écrans flexibles émissifs avec les deux approches décrites ci-dessus, avec quelques modifications :

En ce qui concerne la matrice active, il suffit d'ajouter une couche sacrificielle (par exemple du type polyimide), ce qui permet (cela est connu en soi pour certains écrans actuels) de détacher l'ensemble assemblé du substrat rigide d'origine (en fait la partie de commande 27 ou 127 est plus fine que cela est représenté et est portée par un support rigide ; lorsqu'on enlève ce support, la couche de commande présente une flexibilité tout à fait significative).

En ce qui concerne la partie émissive, il n'y a en principe rien à modifier car la couche émissive, telle qu'elle est conçue et compte tenu de sa minceur, a l'avantage d'être « intrinsèquement flexible ».

Il est à noter que l'invention permet de tirer un grand profit de nanofils pour la réalisation d'écrans émissifs à pixels fixes, en enseignant de dissocier un ensemble homogène de nanofils encapsulés dans une matrice isolante vis-à-vis d'un support (il peut s'agir d'un support ayant servi à la croissance des nanofils, ou d'un support intermédiaire) après assemblage à une matrice activé (complète ou incomplète, en ce qui concerne la délimitation des électrodes de pixels), ce qui permet de former sur la surface ainsi mise à nu une électrode commune ; en d'autres termes, la couche isolante encapsulant les nanofils fait l'objet d'au moins une étape de transfert d'un support sur un autre (la matrice active de pixels).

La formation de la couche contenant les nanofils peut être réalisée de manière complètement indépendante de l'assemblage à la matrice active de pixels, sans en connaître les caractéristiques ; elle peut ainsi être réalisée par des intervenants différents, en des lieux différents et/ou à des moments différents, ce qui contribue à une réduction des coûts, puisque cette étape de formation peut être standardisée indépendamment des applications futures.

Comme indiqué ci-dessus, l'étape d'encapsulation des nanofils dans une couche d'isolant électrique est avantageusement complétée par une gravure partielle (creusement) de la couche d'encapsulation après planarisation au niveau des premières extrémités libres des nanofils, afin d'augmenter sensiblement la surface de prise de contact électrique sur la périphérie des fils (ces fils sont dénudés sur une petite fraction de leur longueur en plus de leurs tranches). En outre, puisqu'il y a un transfert de cette couche d'encapsulation d'un support sur un autre, la formation des nanofils peut être effectuée sur un support choisi indépendamment des caractéristiques de la matrice active à laquelle ceux-ci seront fixés.

## Revendications

1. Procédé de réalisation d'un écran émissif à pixels, selon lequel :
* on forme une matrice active de pixels (1, 27, 127) longée par une première couche formant électrode (2, 26, 102), ces pixels étant répartis selon une distribution déterminée,
* on forme un substrat anisotrope formé d'un ensemble de diodes électroluminescentes constituées respectivement de nanofils (4, 11, 21, 121) parallèles et répartis dans une matrice isolante (5, 12, 22, 122) transversalement à son épaisseur avec une densité supérieure à la densité des pixels, indépendamment de la distribution déterminée des pixels,
* on relie le substrat à la matrice active de pixels, d'une manière telle que seuls des sous-groupes (4A) de ces nanofils sont reliés, par une première extrémité, à des électrodes de pixel distinctes définies dans la couche formant électrode selon la distribution des pixels de la matrice active de pixels, tandis qu'au moins ces sous-groupes de nanofils sont électriquement connectés, par une autre extrémité, à une électrode commune (6, 28, 124+129), ces sous-groupes étant délimités au moment de cette étape de liaison en rendant émissivement inactifs les nanofils du substrat qui sont disposés entre ces sous-groupes.

2. Procédé selon la revendication 1, **caractérisé en ce que**, au cours de l'étape de formation du substrat anisotrope, on dépose sur la matrice isolante une couche de matériau électriquement conducteur (13, 123) qui est en contact électrique avec de premières extrémités de ces nanofils qui sont opposées à de secondes extrémités reliées à un support (10, 20, 120) de cette matrice, l'étape de liaison comportant la mise en contact intime de cette couche de matériau électriquement conducteur avec la couche formant électrode.

3. Procédé selon la revendication 2, **caractérisé en ce que** la couche de matériau électriquement conducteur (13, 123) et la couche (2, 26, 102) formant électrode comportent un même matériau.

4. Procédé selon la revendication 2 ou la revendication 3, **caractérisé en ce que**, lors de l'étape de formation de la matrice active de pixels, on délimite les électrodes de pixel (2, 26) tandis que, au cours de l'étape de formation du substrat, on délimite dans la couche de matériau électriquement conducteur (13) un réseau de plots électriquement conducteurs disjoints (25) tels que chacun soit connecté à au moins la première extrémité d'un nanofil, l'écartement entre des plots adjacents étant supérieur à la largeur de ces premières extrémités et l'écartement entre les électrodes de pixel étant supérieur à la taille des plots, en conséquence de quoi, lors de l'étape de liaison, certains des plots sont connectés à l'une des électrodes de pixel tandis que d'autres plots sont à distance des électrodes de pixel les plus proches en leur étant électriquement isolés, les nanofils reliés à ces plots isolés étant émissivement inactifs.

5. Procédé selon la revendication 4, **caractérisé en ce que** les plots (25) ont des dimensions inférieures à 200 nm tandis que les pixels (26) ont des dimensions inférieures à 1 micron.

6. Procédé selon la revendication 2 ou la revendication 3, **caractérisé en ce que**, au cours de l'étape de formation de la matrice active de pixels, on forme la couche formant électrode sous la forme d'une couche électriquement conductrice continue (102) et, au cours de l'étape de formation du substrat anisotrope, on forme la couche en matériau électriquement conducteur sous la forme d'une couche conductrice continue (123) et, au cours de l'étape de liaison, on délimite dans l'ensemble de nanofils (121) du substrat un réseau de sous-groupes de nanofils séparés par des cloisons en matière isolante (128) tout en délimitant dans la couche continue lesdites électrodes de pixel (126) en regard de ces sous-groupes, les nanofils du substrat situés entre ces sous-groupes étant éliminés.

7. Procédé selon la revendication 6, **caractérisé en ce que** l'on délimite les sous-groupes de nanofils (121) et les électrodes de pixel (126) par gravure au travers du substrat, au travers de la couche conductrice continue (123) et jusqu'au travers de la couche continue (102) formant électrode puis **en ce que** l'on procède au remplissage des zones gravées avec de la matière isolante (128).

8. Procédé selon la revendication 7, **caractérisé en ce que** le matériau isolant de remplissage (128) est le même que le matériau de la matrice isolante (122).

9. Procédé selon l'une quelconque des revendications 1 à 8, **caractérisé en ce que**, au cours de l'étape de formation du substrat anisotrope,
- on provoque la formation dudit ensemble de nanofils (11) à partir d'un substrat de croissance (10),
- on encapsule cet ensemble de nanofils dans la matrice isolante (12) en sorte de laisser à nu de premières extrémités des nanofils.

10. Procédé selon l'une quelconque des revendications 1 à 9, **caractérisé en ce que** l'on forme l'électrode commune (28) après mise en contact de la matrice active de pixels avec ce substrat anisotrope, les électrodes de pixel étant délimitées.

11. Procédé selon l'une quelconque des revendications 1 à 10, **caractérisé en ce que** les nanofils sont distribués dans la matrice isolante de manière aléatoire mais avec une densité sensiblement constante.

12. Ecran émissif à pixels adapté à être réalisé par le procédé selon l'une quelconque des revendications 1 à 11, comportant :
- une matrice active de pixels (1, 27, 127) longée par des électrodes de pixels (2, 26, 126), ces pixels étant répartis selon une distribution déterminée,
- une pluralité de plots conducteurs (25, 125) en contact avec les électrodes de pixels en leur étant sélectivement connectés,
- une pluralité de diodes électroluminescentes constituées chacune de nanofils (11, 21, 121) parallèles et répartis dans une matrice isolante (12, 22, 122) transversalement à son épaisseur en sorte de former un substrat émissif anisotrope et ces nanofils étant répartis en sous-groupes respectivement connectés, par une première extrémité, à un côté des plots conducteurs, ces plots conducteurs étant assemblés, par leur côté opposé, sur les électrodes de pixels, aucun plot n'étant connecté à plus d'une électrode de pixel, et une électrode commune (6, 28, 124+129) connectée à au moins ces sous-groupes de nanofils par une autre extrémité de ceux-ci.

13. Ecran selon la revendication 12, **caractérisé en ce qu'**à chaque électrode de pixel (26) sont connectés plusieurs plots (25), l'écartement entre ces plots étant supérieur à la largeur des nanofils (21), et les dimensions de chaque plot étant inférieures à l'écartement existant entre des électrodes de pixel adjacentes.

14. Ecran selon la revendication 12, **caractérisé en ce qu'**à chaque électrode de pixel (126) correspond un seul plot (125) de mêmes dimensions, tous les nanofils (121) étant répartis entre lesdits sous-groupes.

15. Ecran selon l'une quelconque des revendications 12 à 13, **caractérisé en ce que** les nanofils (21) du substrat émissif anisotrope sont répartis dans la matrice isolante indépendamment de la distribution des pixels (26), des nanofils situés entre les sous-groupes connectés aux électrodes de pixel au travers desdits plots étant émissivement inactifs.

16. Ecran selon l'une quelconque des revendications 12 à 15, **caractérisé en ce que** la matrice active de pixels comporte en surface, pour la couche formant les électrodes (26, 126), un matériau identique à celui des plots conducteurs (25, 125).

## Patentansprüche

1. Verfahren zur Herstellung eines Sendebildschirms mit Pixel, bei dem:
* eine aktive Pixelmatrix (1, 27, 127) gebildet wird, die durch eine erste eine Elektrode (2, 26, 202) bildende Schicht verlängert ist, wobei diese Pixel in einer bestimmten Verteilung verteilt sind,
* ein anisotropes Substrat gebildet wird, das aus einer Gesamtheit von Leuchtdioden besteht, die jeweils von parallelen Nanofäden (4, 11, 21, 121) gebildet sind, die in einer Isoliermatrix (5, 12, 22, 122) quer zu ihrer Dicke mit einer größeren Dichte als die Dichte der Pixel unabhängig von der bestimmten Verteilung der Pixel verteilt sind,
* das Substrat mit der aktiven Pixelmatrix derart verbunden wird, dass nur Untergruppen (4A) dieser Nanofäden mit einem ersten Ende mit getrennten Pixelelektroden, die in der die Elektrode bildenden Schicht gemäß der Verteilung der Pixel der aktiven Pixelmatrix definiert sind, verbunden sind, während mindestens diese Untergruppen von Nanofäden elektrisch mit einem weiteren Ende an eine gemeinsame Elektrode (6, 28, 124+129) angeschlossen sind, wobei diese Untergruppen zum Zeitpunkt dieses Verbindungsschrittes begrenzt werden, wobei die Nanofäden des Substrats, die zwischen diesen Untergruppen angeordnet sind, emissiv inaktiv gesetzt werden.

2. Verfahren nach Anspruch 1, **dadurch gekennzeichnet, dass** während des Schrittes der Bildung des anisotropen Substrats auf die Isoliermatrix eine Schicht aus einem elektrisch leitenden Material (13, 123) aufgebracht wird, die mit ersten Enden dieser Nanofäden in elektrischem Kontakt sind, die zweiten Enden gegenüberliegen, die mit einem Träger (1) dieser Matrix verbunden sind, wobei der Verbindungsschritt die Herstellung eines engen Kontakts dieser Schicht aus elektrisch leitendem Material mit der die Elektrode bildenden Schicht umfasst.

3. Verfahren nach Anspruch 2, **dadurch gekennzeichnet, dass** die Schicht aus elektrisch leitendem Material (13, 123) und die die Elektrode bildende Schicht (2, 26, 102) ein selbes Material umfassen.

4. Verfahren nach Anspruch 2 oder Anspruch 3, **dadurch gekennzeichnet, dass** bei dem Schritt der Bildung der aktiven Pixelmatrix die Pixelelektroden (2, 26) begrenzt werden, während in dem Schritt der Bildung des Substrats in der Schicht aus elektrisch leitendem Material (13) ein Netz von getrennten elektrisch leitenden Kontakten (25) begrenzt ist, so dass jeder mit mindestens dem ersten Ende eines Nanofadens verbunden ist, wobei der Abstand zwischen aneinandergrenzenden Kontakten größer als die Breite dieser ersten Enden und der Abstand zwischen den Pixelelektroden größer als die Größe der Kontakte ist, weshalb bei dem Verbindungsschritt gewisse der Kontakte an eine der Pixelelektroden angeschlossen werden, während andere Kontakte von den nächsten Pixelelektroden beabstandet sind, wobei sie von ihnen elektrisch isoliert sind, wobei die mit diesen isolierten Kontakten verbundenen Nanofäden emissiv inaktiv sind.

5. Verfahren nach Anspruch 4, **dadurch gekennzeichnet, dass** die Kontakte (25) Abmessungen unter 200 nm haben, während die Pixel (26) Abmessungen unter 1 Mikrometer haben.

6. Verfahren nach Anspruch 2 oder Anspruch 3, **dadurch gekennzeichnet, dass** während des Schrittes der Bildung der aktiven Pixelmatrix die die Elektrode bildende Schicht in Form einer kontinuierlichen elektrisch leitenden Schicht ausgebildet wird, und dass während des Schrittes der Bildung des anisotropen Substrats (102) die Schicht aus elektrisch leitendem Material in Form einer kontinuierlichen leitenden Schicht (123) ausgebildet wird, und dass während des Verbindungsschrittes in der Gesamtheit von Nanofäden (121) des Substrats ein Netz von Untergruppen von Nanofäden begrenzt wird, die durch Trennwände aus Isoliermaterial (128) getrennt sind, wobei in der kontinuierlichen Schicht die Pixelelektroden (126) gegenüber diesen Untergruppen begrenzt werden, wobei die Nanofäden des Substrats, die sich zwischen diesen Untergruppen befinden, beseitigt werden.

7. Verfahren nach Anspruch 6, **dadurch gekennzeichnet, dass** die Untergruppen von Nanofäden (121) und die Pixelelektroden (126) durch Gravur durch das Substrat, durch die kontinuierliche leitende Schicht (123) und bis durch die die Elektrode bildende kontinuierliche Schicht (102) begrenzt werden, und dass dann die Befüllung der gravierten Zonen mit Isoliermaterial (128) vorgenommen wird.

8. Verfahren nach Anspruch 7, **dadurch gekennzeichnet, dass** das Isolierfüllmaterial (128) dasselbe wie das Material der Isoliermatrix (122) ist.

9. Verfahren nach einem der Ansprüche 1 bis 8, **dadurch gekennzeichnet, dass** während des Schrittes der Bildung des anisotropen Substrats
- die Bildung der Gesamtheit von Nanofäden (11) aus einem Wachstumssubstrat (10) hervorgerufen wird,
- diese Gesamtheit von Nanofäden in der Isoliermatrix (12) eingekapselt wird, wobei erste Enden der Nanofäden frei gelassen werden.

10. Verfahren nach einem der Ansprüche 1 bis 9, **dadurch gekennzeichnet, dass** die gemeinsame Elektrode (28) nach Herstellung eines Kontakts zwischen der aktiven Matrix und diesem anisotropen Substrat gebildet wird, wobei die Pixelelektroden begrenzt werden.

11. Verfahren nach einem der Ansprüche 1 bis 10, **dadurch gekennzeichnet, dass** die Nanofäden in der Isoliermatrix zufällig aber mit einer im Wesentlichen konstanten Dichte verteilt werden.

12. Sendebildschirm mit Pixel, der geeignet ist, durch das Verfahren nach einem der Ansprüche 1 bis 11 verwirklicht zu werden, umfassend:
- eine aktive Pixelmatrix (1, 27, 127), die durch Pixelelektroden (2, 26, 126) verlängert ist, wobei diese Pixel in einer bestimmten Verteilung verteilt sind,
- eine Vielzahl von leitenden Kontakten (25, 125), die mit den Pixelelektroden in Kontakt sind, wobei sie selektiv an sie angeschlossen sind,
- eine Vielzahl von Leuchtdioden, die jeweils aus parallelen Nanofäden (11, 21, 121), die in einer Isoliermatrix (12, 22, 122) quer zu ihrer Dicke verteilt sind, um ein anisotropes emissives Substrat zu bilden, wobei diese Nanofäden in Untergruppen verteilt sind, die jeweils mit einem ersten Ende an eine Seite der leitenden Kontakte angeschlossen sind, wobei diese leitenden Kontakte mit ihrer gegenüberliegenden Seite mit Pixelelektroden verbunden sind, wobei kein Kontakt an mehr als eine Pixelelektrode angeschlossen ist, und eine gemeinsame Elektrode (6, 28, 124+129), die an mindestens diese Untergruppen von Nanofäden durch ein weiteres Ende derselben angeschlossen ist.

13. Bildschirm nach Anspruch 12, **dadurch gekennzeichnet, dass** an jede Pixelelektrode (26) mehrere Kontakte (25) angeschlossen sind, wobei der Abstand zwischen diesen Kontakten größer als die Breite der Nanofäden (21) ist, und wobei die Abmessungen jedes Kontakts kleiner als der Abstand zwischen aneinandergrenzenden Pixelelektroden ist.

14. Bildschirm nach Anspruch 12, **dadurch gekennzeichnet, dass** jeder Pixelelektrode (126) ein einziger Kontakt (125) mit denselben Abmessungen entspricht, wobei alle Nanofäden (121) zwischen den Untergruppen verteilt sind.

15. Bildschirm nach einem der Ansprüche 12 bis 13, **dadurch gekennzeichnet, dass** die Nanofäden (21) des anisotropen emissiven Substrats in der Isoliermatrix unabhängig von der Verteilung der Pixel (26) verteilt sind, wobei Nanofäden, die sich zwischen den Untergruppen befinden, die an die Pixelelektroden über die Kontakte angeschlossen sind, emissiv inaktiv sind.

16. Bildschirm nach einem der Ansprüche 12 bis 15, **dadurch gekennzeichnet, dass** die aktive Pixelmatrix an der Oberfläche für die die Elektroden (26, 126) bildende Schicht ein identisches Material wie jenes der leitenden Kontakte (25, 125) umfasst.

## Claims

1. A method for producing an pixel emissive screen according to which:
* a matrix of active pixels (1, 27, 127) is formed along which runs a first electrode forming layer (2, 26, 102), said pixels being arranged according to a determined distribution,
* an anisotropic substrate is formed from a set of light emitting diodes constituted respectively by nanowires (4, 11, 21, 121) distributed in an insulating matrix (5, 12, 22, 122) and arranged parallel and transversely to the thickness of said matrix, and having a density greater than the density of the pixels, irrespective of the determined distribution of the pixels,
* the substrate is connected to the active pixel matrix in such manner that only sub-groups (4A) of said nanowires are connected at a first end to separate pixel electrodes defined in the electrode forming layer according to the distribution of the pixels in the active pixel matrix, whereas at least said sub-groups of nanowires, are electrically connected, by the other end thereof, to a common electrode (6, 28, 124+129), said sub-groups being delimited during said connection step by rendering emissively inactive the nanowires of the substrate that are arranged between said sub-groups.

2. The method according to claim 1, **characterized in that** a layer of electrically conductive material (13, 123) that is in electrical contact with first ends of said nanowires that are opposite to the second ends connected to a support (10, 20, 120) for said matrix, is deposited on the insulating matrix during the step of forming the anisotropic substrate, wherein the connecting step comprises placing said layer of electrically conductive material in close contact with the electrode forming layer.

3. The method according to claim 2, **characterized in that** the layer of electrically conductive material (13, 123) and the said electrode forming layer (2, 26, 102) contain the same material.

4. The method according to claim 2, **characterized in that** the pixel electrodes (2, 26) are delimited during the step of forming the active pixel matrix, whereas during the step of forming the substrate, an array of separate electrically conductive contact points (25) is delimited in the layer of electrically conductive material (13), such that each contact point is connected to at least the first end of a nanowire, the spacing between adjacent contact points being greater than the width of said first ends, and the spacing between the pixel electrodes being greater than the size of the contact points, and consequently during the connection step, certain of the contact points are connected to one of the pixel electrodes while other contact points are at a distance from the closest pixel electrodes and are electrically insulated therefrom, the nanowires connected to said insulated contact points being emissively inactive.

5. The method according to claim 4, **characterized in that** the contact points (25) have dimensions smaller than 200 nm, and the pixels (26) have dimensions smaller than 1 micron.

6. The method according to claim 2 or claim 3, **characterized in that** the electrode forming layer is created in the form of a continuous, electrically conductive layer (102) during the step of forming the active pixel matrix, and the layer of electrically conductive material is created in the form of a continuous conductive layer (123) during the step of forming the anisotropic substrate, and a network of nanowire sub-groups separated by partitions made from insulating material (128) is delimited within the set of nanowires (121) of the substrate during the connection step, at the same time delimiting said pixel electrodes (126) from said sub-groups in the continuous layer, the nanowires of the substrate located between said sub-groups being eliminated.

7. The method according to claim 6, **characterized in that** the sub-groups of nanowires (121) and the pixel electrodes (126) are delimited by etching through the substrate, through the continuous conductive layer (123) and as far as through the continuous electrode forming layer (102), and **in that** the etched zones are then filled with the insulating material (128).

8. The method according to claim 7, **characterized in that** the insulating material for filling (128) is the same as the material of the insulating matrix (122).

9. The method according to any of claims 1 to 8, **characterized in that** during the step of forming the anisotropic substrate,
- the formation of said set of nanowires (11) is initiated using a growth substrate (10),
- said set of nanowires is encapsulated in the insulating matrix (12) so as to leave the first ends of the nanowires bare.

10. The method according to any of claims 1 to 9, **characterized in that** the common electrode (28) is formed after the active pixel matrix is placed in contact with said anisotropic substrate, said pixel electrodes being delimited.

11. The method according to any of claims 1 to 10, **characterized in that** the nanowires are distributed in the insulating matrix randomly but with a substantially constant density.

12. An emissive pixel screen having a design that may be created by the method according to any of claims 1 to 11, and comprising:
- a matrix of active pixels (1, 27, 127) along which run pixel electrodes (2, 26, 126), said pixels being arranged according to a determined distribution,
- a plurality of conductive contact points (25, 125) that are in contact with and selectively connected to the pixel electrodes,
- a plurality of light emitting diodes each constituted by nanowires (11, 21, 121) distributed in an insulating matrix (12, 22, 122) and arranged parallel and transversely to the thickness of said matrix in such manner as to form an anisotropic emissive substrate, and said nanowires being distributed in sub-groups respectively connected by a first end to one side of the conductive contact points, the other side of said contact points being mounted on the pixel electrodes, wherein no contact point is connected to more than one pixel electrode, and a common electrode (6, 28, 124+129) connected to at least said sub-groups of nanowires by another end thereof.

13. The screen according to claim 12, **characterized in that** several contact points (25) are connected to each pixel electrode (26), the spacing between said contact points being greater than the width of the nanowires (21), and the dimensions of each contact point being smaller than the spacing between adjacent pixel electrodes.

14. The screen according to claim 12, **characterized in that** a single contact point (125) having the same dimensions corresponds to each pixel electrode (126), all of the nanowires (121) being distributed between said sub-groups.

15. The screen according to either of claims 12 or 13, **characterized in that** the nanowires (21) of the anisotropic emissive substrate are distributed in the insulating matrix irrespective of the distribution of the pixels (26), nanowires situated between that sub-groups connected to the pixel electrodes via said contact points being emissively inactive.

16. The screen according to any of claims 12 to 15, **characterized in that** the surface of the active matrix of pixels comprises a material that is identical to that of the conductive contact points (25, 125) for the layer forming the electrodes (26, 126).
